(19) **Europäisches Patentamt / European Patent Office / Office européen des brevets**

(11) **EP 1 390 769 B1**

(12) **FASCICULE DE BREVET EUROPEEN**

(45) Date de publication et mention
de la délivrance du brevet:
**07.07.2010 Bulletin 2010/27**

(51) Int Cl.:
**G01R 19/25** (2006.01)    **G01R 19/00** (2006.01)

(21) Numéro de dépôt: **02738241.5**

(22) Date de dépôt: **13.05.2002**

(86) Numéro de dépôt international:
**PCT/FR2002/001597**

(87) Numéro de publication internationale:
**WO 2002/093182 (21.11.2002 Gazette 2002/47)**

(54) **DISPOSITIF D'ECHANTILLONNAGE DE SIGNAL ELECTRIQUE HAUTE FREQUENCE**

VORRICHTUNG ZUR ABTASTUNG EINES ELEKTRISCHEN HOCHFREQUENZSIGNALS

HIGH-FREQUENCY ELECTRICAL SIGNAL SAMPLING DEVICE

(84) Etats contractants désignés:
**DE GB IT NL**

(30) Priorité: **15.05.2001 FR 0106365**

(43) Date de publication de la demande:
**25.02.2004 Bulletin 2004/09**

(73) Titulaire: **Commissariat à l'Énergie Atomique
et aux Énergies Alternatives
75015 Paris (FR)**

(72) Inventeurs:
• **GHIS, Anne
F-38400 Saint Martin D'heres (FR)**
• **OUVRIER-BUFFET, Patrice
F-74410 Saint-Jorioz (FR)**
• **ROLLAND, Nathalie
F-59650 Villeneuve D'Ascq (FR)**
• **BENLARBI-DELAI, Aziz
F-59650 Villeneuve D'Ascq (FR)**

(74) Mandataire: **Poulin, Gérard et al
Brevalex
3, rue du Docteur Lancereaux
75008 Paris (FR)**

(56) Documents cités:
**GB-A- 2 157 519    US-A- 4 825 103
US-A- 5 471 162**

EP 1 390 769 B1

**Description**

Domaine technique

L'invention concerne un dispositif d'échantillonnage de signal électrique haute fréquence et, plus particulièrement, un dispositif d'échantillonnage d'impulsion électrique de très courte durée.

La métrologie d'impulsions permet de décrire l'évolution temporelle d'impulsions électriques très brèves ayant, par exemple, une durée de l'ordre de quelques dizaines ou quelques centaines de picosecondes.

De telles impulsions sont généralement issues de détecteurs de rayonnement très rapides, qui convertissent en impulsions électriques l'énergie d'une impulsion de rayonnement qu'ils reçoivent, par exemple une impulsion de rayonnement X, gamma, visible, ou infrarouge. De tels rayonnements peuvent être émis par des sources de rayonnement ultrarapides, telles que des lasers ou des sources de rayonnement synchrotron. Ils peuvent également être le résultat d'une interaction laser-matière provoquée par un laser ultrarapide (c'est-à-dire dont la durée de l'impulsion est du domaine de la picoseconde ou de la femtoseconde).

L'invention peut s'appliquer à toute mesure de signal électrique très bref, notamment non répétitif, en particulier dans la physique d'événements, ou dans la mesure d'événements, générés par des phénomènes dont la durée est de l'ordre de la picoseconde.

Etat de la technique

Il est actuellement connu des oscilloscopes à échantillonnage pour la mesure de signaux dont le spectre s'étend, par exemple, jusqu'à 50GHz ou 70GHz. Ces appareils permettent de mesurer des impulsions répétitives. La fréquence d'échantillonnage est variable, de 250 KHz à 1 GHz.

Pour mesurer des impulsions uniques, sont également connus des analyseurs de transitoires qui permettent de restituer des spectres allant jusqu'à, par exemple, 5GHz ou 7GHz.

Les analyseurs de transitoires ont pour fonction d'enregistrer des signaux monocoup très rapides, tels qu'il en existe dans les domaines des lasers, du nucléaire, des radars ou des télécommunications. Ces signaux monocoup sont de très faible durée et ont une très grande dynamique.

Les analyseurs de transitoires sont constitués d'un capteur rapide, d'une mémoire de stockage et d'un convertisseur analogique/numérique. Les générations successives d'analyseur ont utilisé différents principes pour réaliser les fonctions de discrétisation du signal analogique qui sont nécessaires aussi bien dans le temps que sur l'amplitude du signal. Les tubes à rayon cathodique à écriture rapide ont tout d'abord été utilisés pour capturer et stocker rapidement l'information. L'information ainsi capturée et stockée est alors discrétisée en temps et en amplitude puis digitalisée. Une génération plus récente d'analyseurs stocke séquentiellement des échantillons analogiques ou digitalisés, par exemple, à l'aide de l'association d'un convertisseur flash et d'une mémoire rapide. La fréquence d'échantillonnage détermine l'intervalle de temps allouée au système pour capturer, digitaliser et stocker l'information. Le brevet GB-A-2 157 519 divulgue un dispositif d'échantillonnage comprenant trois interrupteurs et deux capacités.

Parmi les prototypes de laboratoire, est également connu le dispositif décrit dans le brevet US-5 471 162. Un tel dispositif repose sur le principe de l'échantillonnage spatial d'une impulsion. Une impulsion se propage sur une ligne de propagation. Il en résulte une équivalence spatiale de l'évolution temporelle de cette impulsion qui se propage sur la ligne avec une vitesse dépendant des caractéristiques physiques de celle-ci. A un instant déterminé, si la ligne est de longueur suffisante, la totalité de l'impulsion est spatialement répartie le long de la ligne.

Si des échantillonneurs sont disposés le long de la ligne de propagation, leur actionnement simultané permet de réaliser un échantillonnage complet de l'impulsion, avec un pas temporel égal au pas spatial des échantillonneurs, divisé par la vitesse de propagation.

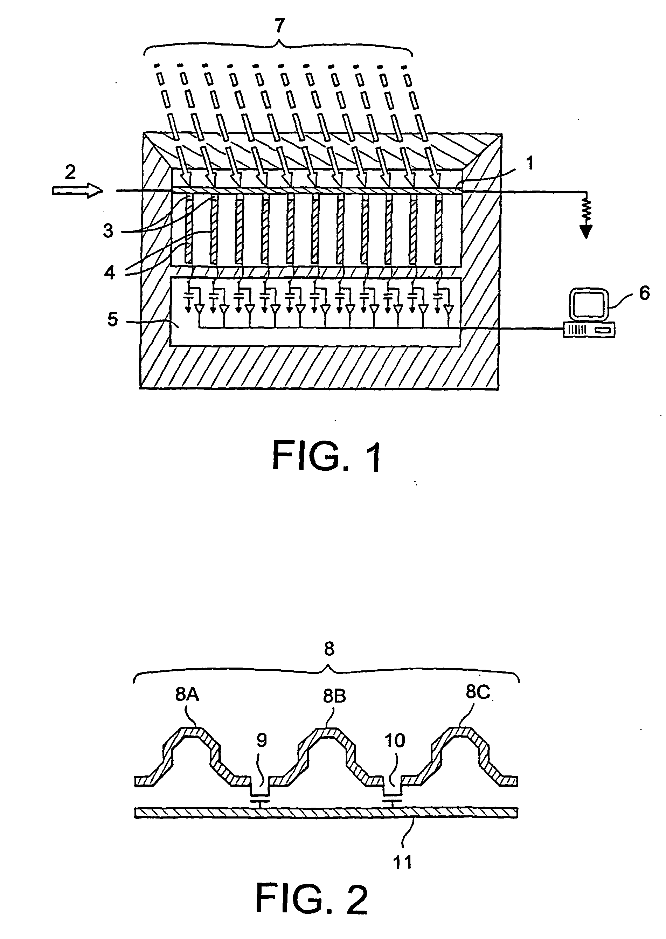

On connaît également un dispositif opto-échantillonneur qui mesure des signaux de bande passante jusqu'à 35GHz. Ce dispositif est illustré sur la figure 1. Il comporte une ligne de propagation 1 le long de laquelle se propage un signal impulsionnel 2 à mesurer. Le long de la ligne de propagation sont disposées, de manière régulière, des portes d'échantillonnage 3 en matériau photoconducteur (CdTe). Ces portes d'échantillonnage sont associées à des lignes de prélèvement 4, chacune étant elle-même suivie d'un moyen de lecture des charges. L'ensemble des moyens de lecture des charges est rassemblé dans un dispositif 5 de lecture des charges. Ces moyens de lecture de charges sont reliés à un ordinateur 6 programmé pour mesurer les charges relatives à chaque canal et analyser le signal impulsionnel 2. Les portes d'échantillonnage 3 sont fermées grâce à une impulsion lumineuse de déclenchement 7 qui se répartit sur l'ensemble des portes d'échantillonnage. Pour déclencher l'échantillonnage, ce dispositif nécessite ainsi un flash optique ayant une énergie de quelques dizaines de nanojoules et une durée de l'ordre de la picoseconde.

Le document FR-97 06534 décrit un échantillonneur électrique monocoup pour impulsions courtes. Le principe de cet échantillonneur est illustré en figure 2.

Une structure ou ligne 8 de propagation d'impulsions électriques comporte une pluralité de tronçons 8A, 8B, 8C. Les différents tronçons sont reliés deux à deux par des interrupteurs 9, 10 constitués, par exemple, de MESFET AsGa ou Si, de transistors MOS, ou de transistors bipolaires sur silicium.

Des moyens de commande des interrupteurs 9 et 10 comportent, par exemple, une structure de propagation d'impulsions de déclenchement 11, à laquelle sont connectés les interrupteurs 9 et 10.

Sur la figure 2, seuls trois tronçons de ligne 8A, 8B, 8C ont été représentés, mais la ligne peut comporter un nombre quelconque de tronçons de ligne reliés deux à deux par des interrupteurs.

Un signal à échantillonner se propage le long de la structure de propagation ou ligne de propagation 8. Le long de la ligne de propagation 11 se propage un signal de synchronisation, par exemple un créneau échelon de tension. Les interrupteurs sont normalement passants et l'échelon de tension a pour fonction d'ouvrir les interrupteurs. L'échelon de tension permet alors d'isoler chaque tronçon de la ligne de propagation, tronçon qui sert alors de capacité de stockage.

La totalité des charges véhiculées par l'impulsion est alors confinée dans les différents tronçons 8A, 8B, 8C constituant la structure de propagation de l'impulsion.

La structure illustrée sur la figure 2 comporte donc :

- d'une part, une première structure de propagation 8, où se propage la quantité de charges à mesurer, et qui est constituée de tronçons reliés deux à deux par des interrupteurs initialement fermés,
- d'autre part, une seconde structure de propagation 11 dans laquelle peut se propager un signal de synchronisation de type échelon de tension; l'échelon de tension permet de modifier la commande de l'état d'un interrupteur de façon que ce dernier s'ouvre et isole les deux tronçons auquel il est relié ; les charges piégées dans un tronçon compris entre deux interrupteurs sont alors lues par un dispositif approprié.

Le dispositif est complété par des moyens pour générer un signal de synchronisation, reliés à la structure 11 de propagation d'impulsions de synchronisation. Par ailleurs, ils peuvent être reliés à un dispositif de lecture des charges dans les tronçons.

Ces échantillonneurs ont une bande passante limitée, liée à la bande passante de la ligne elle-même. De plus la sensibilité de détection (c'est-à-dire la quantité de charges prélevée dans le signal) est également limitée. En ce qui concerne l'opto-échantillonneur, l'utilisation d'un laser picoseconde de forte puissance impose des contraintes expérimentales et des contraintes en terme de coûts très importantes.

Enfin, tous ces dispositifs nécessitent une ligne de propagation très longue, altérant le signal de façon non uniforme.

L'invention ne présente pas les inconvénients mentionnés ci-dessus.

Exposé de l'invention

En effet l'invention concerne un dispositif d'échantillonnage de signal haute fréquence qui se propage dans une structure de propagation. Le dispositif comprend un premier étage pour prélever sous l'action d'un premier signal de commande un premier échantillon de signal à un premier instant t1 et au moins un deuxième étage en série avec le premier étage pour prélever sous l'action d'un deuxième signal de commande, à partir du premier échantillon prélevé, à un deuxième instant t2 supérieur à t1, un deuxième échantillon représentatif du premier échantillon, la durée de vie du deuxième échantillon dans le deuxième étage étant très sensiblement supérieure à la durée de vie du premier échantillon dans le premier étage.

L'invention concerne également un système d'échantillonnage de signal haute fréquence se propageant dans une structure de propagation, **caractérisé en ce qu**'il comprend au moins un dispositif d'échantillonnage selon l'invention.

L'invention concerne encore un analyseur de transitoire **caractérisé en ce qu**'il comprend au moins un dispositif d'échantillonnage selon l'invention.

Le dispositif d'échantillonnage selon l'invention permet avantageusement de transmettre l'information capturée par échantillonnage d'étage en étage, chaque étage étant moins rapide que celui qui le précède, jusqu'à ramener cette information dans un environnement temporel qui en permette un traitement standard. Par traitement standard, il faut entendre, par exemple, un traitement de l'information dans une gamme de fréquences de l'ordre de quelques dizaines de mégahertz.

Brève description des figures

D'autres caractéristiques et avantages de l'invention apparaîtront à la lecture d'un mode de réalisation préférentiel de l'invention fait en référence aux figures jointes, parmi lesquelles :

- les figures 1 et 2 représentent des systèmes d'échantillonnage selon l'art antérieur ;
- la figure 3 représente un dispositif d'échantillonnage selon l'invention ;

- la figure 4 représente des courbes illustrant l'évolution des tensions en différents points d'un dispositif d'échantillonnage selon l'invention;
- la figure 5 représente un perfectionnement du dispositif d'échantillonnage représenté en figure 3 ;
- la figure 6 représente un schéma de principe de système d'échantillonnage selon l'invention ;
- la figure 7 représente un exemple de mise en oeuvre de système d'échantillonnage tel que représenté en figure 6 ;
- la figure 8 représente des chronogrammes de signaux de dialogue et de commutation mis en oeuvre pour réaliser une séquence d'échantillonnage selon l'invention.

Sur toutes les figures, les mêmes repères désignent les mêmes éléments.

Description détaillée de modes de mise en oeuvre de l'invention

Les figures 1 et 2 ont été décrites précédemment. Il est donc inutile d'y revenir.

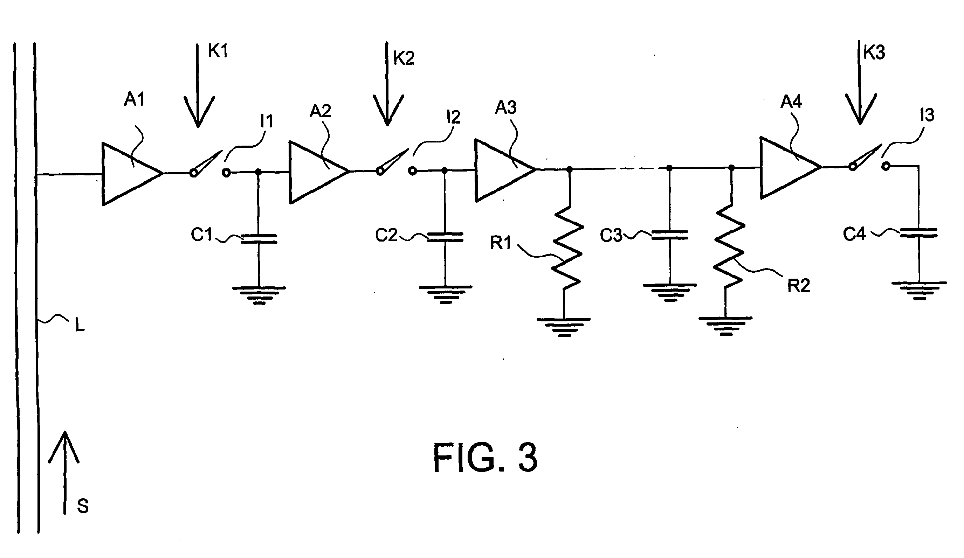

La figure 3 représente un dispositif d'échantillonnage selon l'invention.

Le dispositif d'échantillonnage comprend au moins trois étages élémentaires : un étage haute fréquence (étage HF), un étage basse fréquence (étage BF) et un étage tampon de sortie (buffer de sortie). L'étage HF comprend un amplificateur suiveur de tension A1, un interrupteur I1 et une capacité C1. L'étage BF comprend un amplificateur suiveur de tension A2, un interrupteur I2 et une capacité C2. Le buffer de sortie comprend un amplificateur A3 et une résistance R1.

Le dispositif d'échantillonnage peut également comprendre un quatrième étage élémentaire constitué par un échantillonneur-bloqueur standard comprenant une capacité C3, une résistance R2, un amplificateur A4, un interrupteur I3 et une capacité C4. Par échantillonneur-bloqueur standard, il faut entendre un circuit d'échantillonnage fonctionnant, par exemple, à des fréquences de l'ordre de quelques dizaines de mégahertz.

Les différents étages élémentaires sont cascadés en série. Selon l'invention, le quatrième étage (échantillonneur-bloqueur standard) peut avantageusement être relié au troisième étage par l'intermédiaire de connecteurs, de pistes, de lignes ou, plus généralement, de tout moyen permettant d'établir une liaison à distance.

Les interrupteurs I1, I2 et I3 sont commandés par les signaux de commande respectifs K1, K2 et K3. Un interrupteur Ii (i=1, 2, 3) présente une résistance $ri_{on}$ à l'état passant (interrupteur fermé).

Le dispositif d'échantillonnage est connecté à la structure de propagation, par exemple une ligne de transmission L. L'amplificateur A1 est un amplificateur suiveur de tension destiné à isoler la ligne L des variations d'impédance dues aux modifications de l'état des interrupteurs.

Le dispositif d'échantillonnage a pour fonction de prélever la tension présente sur la ligne L à un instant donné. Avant échantillonnage, les interrupteurs I1 et I2 sont fermés (état passant). La charge de la capacité C1 est alors, à chaque instant, l'image du niveau de tension du signal sur la ligne. Lorsque l'ordre d'échantillonnage est donné, le signal de commande K1 ouvre l'interrupteur I1 de sorte que celui-ci est porté à l'état bloqué. La capacité C2 de l'étage BF se charge alors à l'image de la charge de la capacité HF. Les valeurs des capacités C1 et C2 sont choisies de façon que la charge de la capacité C2 à travers la résistance $r2_{on}$ soit effectuée très sensiblement avant que la capacité C1 ne se soit déchargée à travers la résistance de fuite $r1_{off}$ qui apparaît aux bornes de la capacité C1 lorsque l'interrupteur I1 est ouvert.

La condition suivante doit alors être réalisée :

$$r1_{off} \ \text{x} \ C1 = F \ \text{x} \ r2_{on} \ \text{x} \ C2,$$

où F est un facteur multiplicatif très sensiblement supérieur à 1.

Selon un exemple de réalisation non limitatif de l'invention, la capacité C1 peut être égale à 0,3pF et la capacité C2 peut être égale à 10pF. Pour une résistance $r1_{off}$ égale à 100kΩ et une résistance $r2_{on}$ égale à 180Ω, le temps de charge de la capacité C2 est alors égal à 1,8ns et le temps de décharge de la capacité C1 est égal à 30ns. Le facteur F est alors sensiblement égal à 16,6.

Lorsque la charge de la capacité C2 est effectuée, le signal de commande K2 ouvre l'interrupteur I2 qui est alors porté à l'état bloqué. Le signal utile est alors constitué par la charge contenue dans la capacité C2. La durée qui sépare l'ouverture de l'interrupteur I1 de l'ouverture de l'interrupteur I2 est avantageusement choisie pour établir un compromis acceptable entre le temps de charge de la capacité C2 et le temps de décharge de la capacité C1.

L'étage tampon de sortie a pour fonction de recopier l'état de tension de la capacité C2. La tension de sortie recueillie aux bornes de la résistance R1 est alors représentative de la charge contenue dans la capacité C2. Cette tension de sortie est une grandeur fugitive du fait de la décharge de la capacité C2 dans la résistance de fuite $r2_{off}$ qui apparaît aux bornes de la capacité C2 lorsque l'interrupteur I2 est ouvert. La résistance de fuite $r2_{off}$ est, par exemple, égale à 600kΩ. Pour une valeur de capacité C2 égale à 10pF, le temps de décharge de la capacité est alors égal à 6μs. Avantageusement, la durée de vie de l'information échantillonnée est cependant très sensiblement rallongée par rapport à la durée de vie du signal échantillonné par l'étage précédent. Bien avant que la capacité C2 ne soit déchargée, l'information échantillonnée peut ainsi être traitée par un échantillonneur-bloqueur de technologie standard (C3, R2, A4, I3, C4), via une connectique conventionnelle (connecteurs, pistes, lignes, etc.).

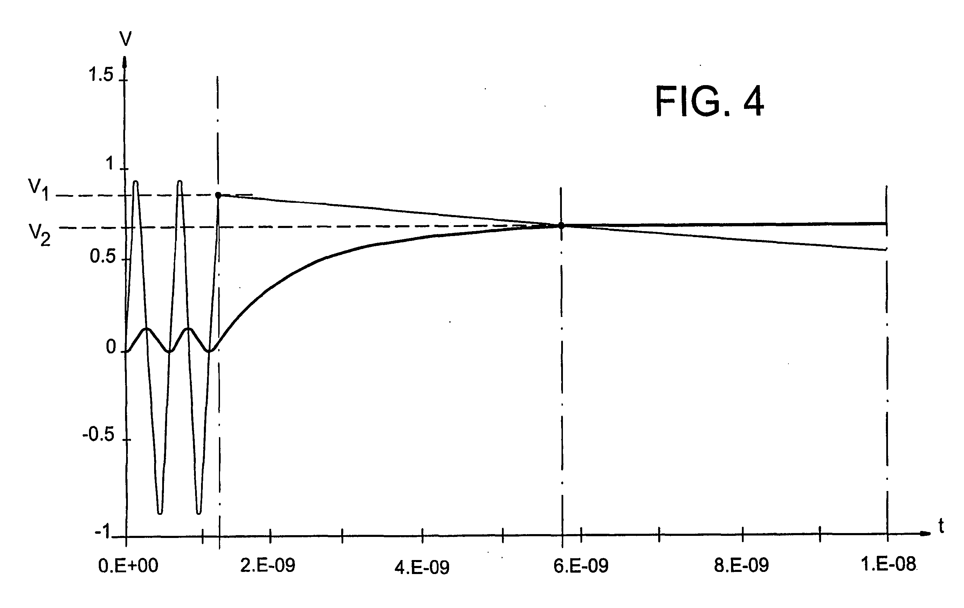

La figure 4 représente, en fonction du temps, l'évolution de la tension aux bornes des capacité C1 et C2. La courbe $V_{C1}$ représente l'évolution de la tension aux bornes de la capacité C1 et la courbe $V_{C2}$ l'évolution de la tension aux bornes de la capacité C2.

A titre d'exemple non limitatif, le signal qui se propage sur la ligne L est choisi sinusoïdal. L'invention concerne cependant tout autre type de signal tel que, par exemple, un signal impulsionnel.

Avant échantillonnage, les interrupteurs I1 et I2 sont fermés (état passant). Le niveau de tension aux bornes de la capacité C1 suit les variations du signal haute fréquence qui se propage sur la ligne L (cf. la fraction sinusoïdale de la courbe $V_{C1}$) alors que le niveau de tension aux bornes de la capacité C2 ne suit pas ces variations (bande passante trop étroite). A l'instant d'échantillonnage t1, l'interrupteur I1 s'ouvre sous l'action de la commande K1. La capacité C1 aux bornes de laquelle est mesurée la tension $V_1$ se décharge alors progressivement à travers la résistance $r1_{off}$. Parallèlement, la capacité C2 se charge pour aligner la tension qui est à ses bornes sur la tension aux bornes de la capacité C1. Sous l'action de la commande K2, l'interrupteur I2 bascule de l'état passant à l'état bloqué à l'instant t2. Comme cela apparaît sur la figure 4, l'instant t2 est préférentiellement l'instant où les tensions aux bornes des capacités C1 et C2 sont sensiblement égales à une même tension $V_2$. La capacité C2 aux bornes de laquelle est mesurée la tension $V_2$ se décharge alors progressivement à travers la résistance de fuite $r2_{off}$. Comme cela a été mentionné précédemment, la constante de temps de décharge de la capacité C2 est très sensiblement supérieure à la constante de temps de décharge de la capacité C1. L'information d'échantillonnage aux bornes de la capacité C2 est alors maintenue pendant une durée suffisamment longue pour pouvoir être traitée par des circuits de technologie standard. A titre d'exemple non limitatif, les instants de blocage t1 et t2 sont choisis de sorte que la durée t2-t1 est comprise entre 5ns et 10ns.

Selon le mode de réalisation de l'invention décrit ci-dessus, deux étages d'échantillonnage (un étage HF et un étage BF) sont utilisés pour obtenir une information échantillonnée qu'il est possible de traiter avec des circuits conventionnels. L'invention concerne également le cas ou plus de deux étages d'échantillonnage sont utilisés pour obtenir une telle information. Cependant, chaque étage d'échantillonnage supplémentaire ajoute un niveau de bruit sur la mesure obtenue. De façon générale, le choix du nombre d'étages d'échantillonnage est alors déterminé par les paramètres suivants :

- la fréquence maximale du signal à échantillonner (cette fréquence peut, par exemple, atteindre 8Ghz voire plus),
- la fréquence des signaux que l'on considère comme pouvant être traités par des circuits conventionnels,
- la dynamique de sortie voulue pour l'ensemble de la fonction d'échantillonnage (cette dynamique est fonction, entre autres, de la technologie disponible pour les interrupteurs (rapport $r_{off}/r_{on}$ selon la fréquence) et du bruit rapporté par chaque étage).

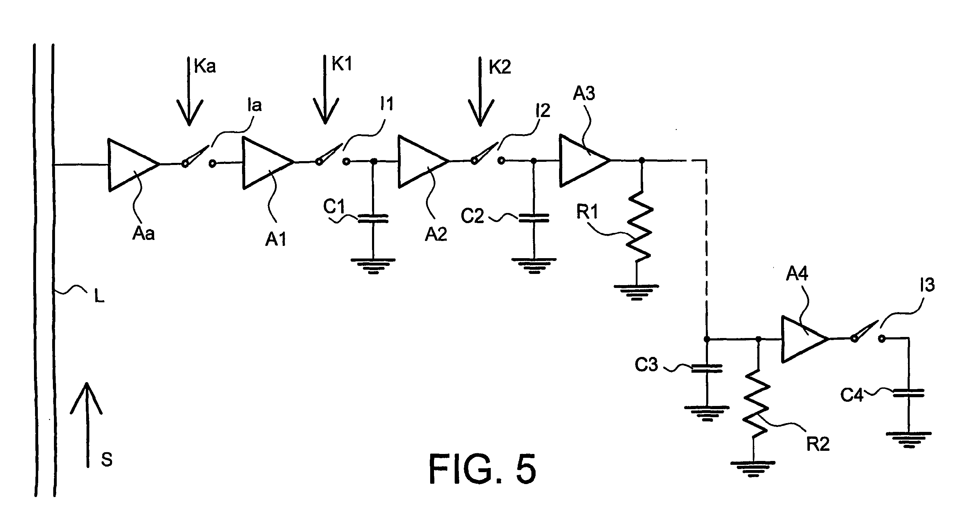

La figure 5 représente un perfectionnement du dispositif d'échantillonnage selon l'invention représenté en figure 3.

En plus des éléments représentés sur la figure 3, le dispositif d'échantillonnage selon le perfectionnement de l'invention comprend un amplificateur Aa et un interrupteur Ia. L'amplificateur Aa et l'interrupteur Ia sont montés en série entre la ligne de propagation L et l'entrée de l'amplificateur A1. De préférence, les caractéristiques de l'amplificateur Aa et de l'interrupteur Ia sont sensiblement identiques, respectivement, aux caractéristiques de l'amplificateur A1 et de l'interrupteur I1. Un signal de commande Ka commande l'interrupteur Ia.

L'ensemble constitué par l'amplificateur Aa et l'interrupteur Ia permet avantageusement d'accroître l'isolation d'impédance entre la ligne L et les circuits situés en amont de l'amplificateur A1, tout en conservant la bande passante et la rapidité de commutation des interrupteurs I1 et I2. De même que précédemment, l'interrupteur I1 est celui qui réalise la fonction d'échantillonnage. Ainsi, l'interrupteur I1 est-il commuté rapidement, exactement à l'instant d'échantillonnage.

L'interrupteur Ia est commuté sensiblement après I1 et de façon moins contraignante que I1 pour ce qui est de la durée et de l'instant de commutation. L'interrupteur Ia a pour fonction d'isoler l'interrupteur I1 du signal présent sur la ligne pendant la période où l'interrupteur I2 est encore passant. Les contraintes relatives à l'interrupteur Ia sont essentiellement relatives à sa bande passante à l'état passant. Sa présence équivaut à sensiblement doubler la résistance $r1_{off}$ sans doubler la résistance $r1_{on}$.

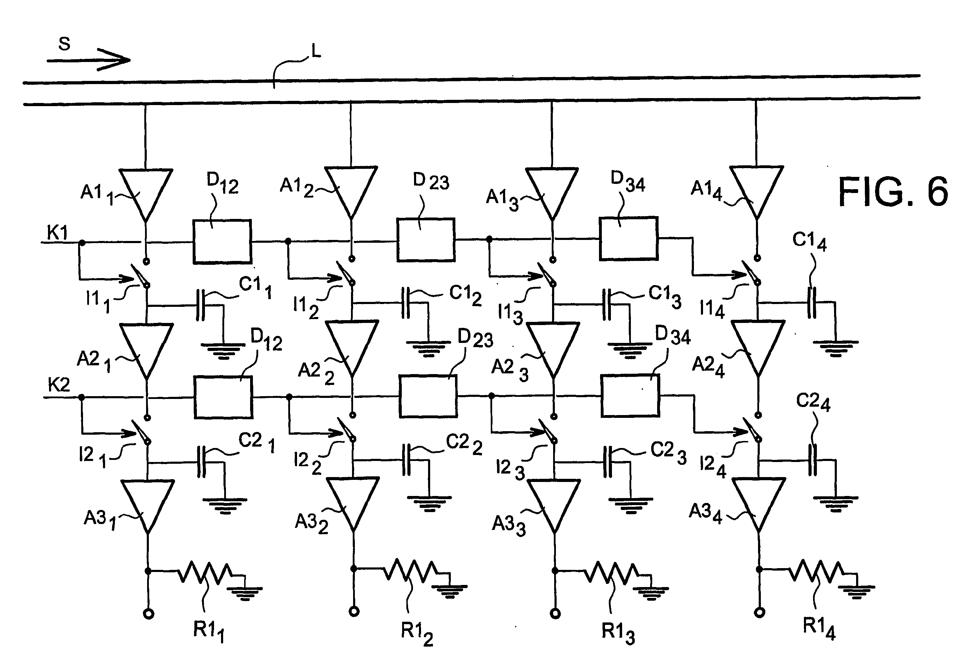

La figure 6 représente, à titre d'exemple, un système d'échantillonnage constitué de quatre dispositifs d'échantillonnage successifs distribués en parallèle le long d'une ligne L. Le dispositif d'échantillonnage de rang i (i=1, 2, 3, 4) comprend un étage HF ($A1_i$, $I1_i$, $C1_i$), un étage BF ($A2_i$, $I2_i$, $C2_i$), et un étage tampon ($A3_i$, $R1_i$).

Le signal de commande d'échantillonnage est transmis de porte en porte avec un délai choisi pour réaliser un pas temporel d'échantillonnage. Un délai $D_{kk+1}$ est ainsi prévu pour retarder les signaux de commande K1 et K2 entre le dispositif d'échantillonnage de rang k et le dispositif d'échantillonnage de rang k+1. Avantageusement, les échantillons prélevés en sortie des dispositifs d'échantillonnage selon l'invention sont traités en parallèle et de façon simultanée.

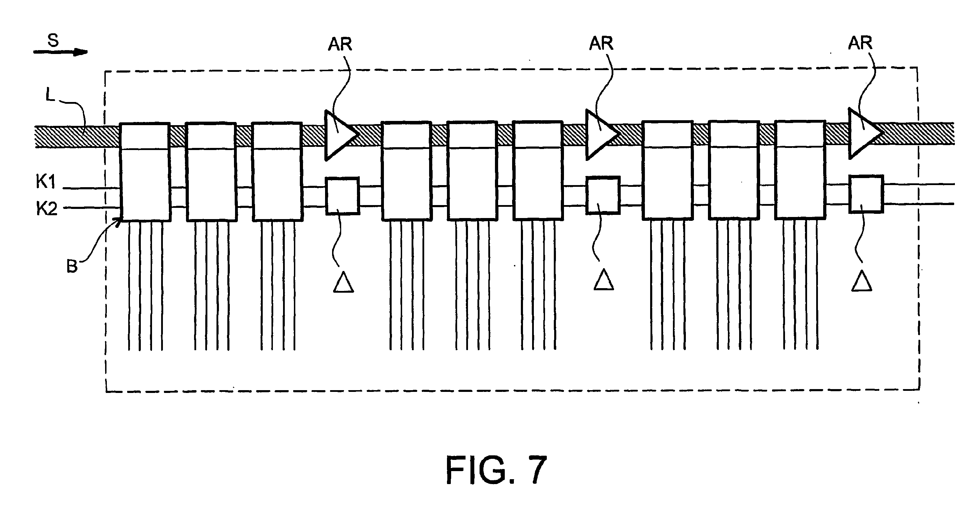

La figure 7 représente un mode de mise en oeuvre de système d'échantillonnage selon la figure 6.

Les dispositifs d'échantillonnage sont regroupés par blocs. Chaque bloc B comprend, par exemple, quatre dispositifs d'échantillonnage. Pour compenser l'atténuation du signal S au cours de la propagation, des amplificateurs AR sont insérés dans la ligne L.

Un amplificateur AR est conçu pour avoir, en fonction de la fréquence, des caractéristiques d'amplification duales des caractéristiques d'atténuation du tronçon de ligne qui le sépare de l'amplificateur qui le précède. Soit $G_L$ le gain de l'élément de ligne entre deux dispositifs d'échantillonnage élémentaires voisins, $G_{AR}$ le gain d'un amplificateur AR, N le nombre de dispositifs d'échantillonnage élémentaires entre deux amplificateurs AR, il vient alors :

$$(N \ x \ G_L) \ x \ G_{AR} = 1,$$

pour toutes les fréquences de la bande considérée.

Chaque amplificateur AR a un bruit propre qui détériore le signal. Le nombre N est alors préférentiellement choisi de façon à optimiser le rapport signal/bruit. Une étude de la propagation du signal effectuée en parallèle à une étude de bruit a permis de déterminer que le nombre N=12 satisfait au mieux les performances en terme de rapport signal/bruit.

Selon l'exemple choisi, les dispositifs d'échantillonnage sont regroupés par bloc de quatre. Comme représenté à titre d'exemple non limitatif sur la figure 7, il s'en suit que trois blocs de dispositifs d'échantillonnage sont placés entre deux amplificateurs AR successifs afin d'optimiser le rapport signal/bruit.

L'insertion d'un amplificateur dans la ligne de propagation L impose un retard au signal lorsque celui-ci traverse l'amplificateur. Pour garder constant le pas temporel d'échantillonnage par rapport au signal, il est alors nécessaire d'insérer un retard équivalent dans la propagation des signaux de commande d'échantillonnage. A cette fin, un circuit de retard Δ impose un délai sur les signaux de commande K1 et K2.

Comme cela a été mentionné plus haut, selon l'invention, les échantillons prélevés en sortie des différents dispositifs d'échantillonnage sont traités en parallèle et de façon simultanée.

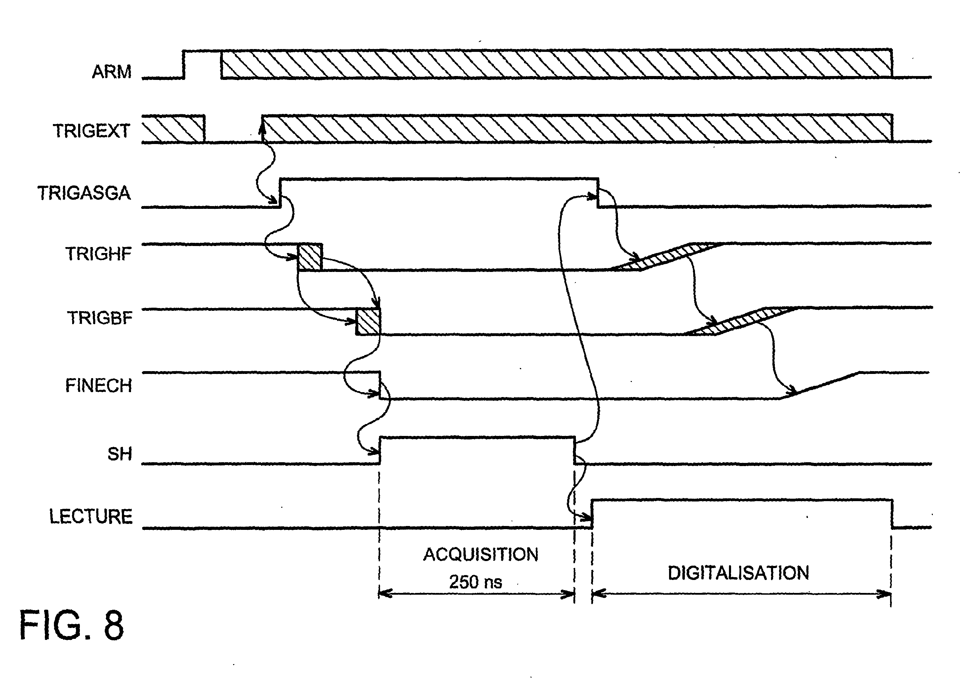

L'enchaînement des signaux de dialogue et de commutation mis en oeuvre pour une séquence d'échantillonnage est représenté en figure 8.

Les courbes de la figure 8 représentent essentiellement les signaux d'échantillonnage et les signaux de dialogue entre un système de mesure d'échantillons et un module échantillonneur selon l'invention.

L'état haut d'un signal « ARM » valide la prise en compte du front de montée d'une impulsion de déclenchement «TRIGEXT» en vue d'une acquisition d'échantillons. Ce front de montée d'impulsion de déclenchement est mis en forme avant d'être transmis au module échantillonneur (cf. signal « TRIGASGA »). Dans le module échantillonneur, le signal mis en forme « TRIGASGA » génère le signal « TRIGHF » qui se propage au niveau des différents étages HF pour générer les signaux de commande K1. Le signal « TRIGASGA » génère ensuite (quelques nanosecondes plus tard) le signal « TRIGBF » qui se propage au niveau des différents étages BF pour générer les signaux de commande K2. Après le dernier échantillonneur, le signal « TRIGBF » (référencé « FINECH » sur la figure 8) est transmis au système de lecture pour informer que tous les échantillons sont disponibles en sortie du module.

Le système de lecture initialise alors, à l'aide d'un signal « SH », une phase d'acquisition dans des échantillonneurs-bloqueurs pendant une durée, par exemple, de 250ns (caractéristique de circuit choisi). Cette phase est asynchrone, déclenchée par le front descendant du signal « FINECH », de façon que les états de décharge des capacités C2 soient reproductibles d'une acquisition à l'autre.

A la fin de cette phase le signal « TRIGASGA » est invalidé, ce qui entraîne, à l'intérieur du module échantillonneur, de proche en proche, le retour de tous les interrupteurs I1 et I2 à l'état passant.

Simultanément, une phase de lecture séquentielle et de digitalisation est initialisée à une fréquence d'horloge de quelques mégahertz. Quand cette phase est finie, le système autorise la prise en compte d'une nouvelle demande d'acquisition par le signal « ARM ».

**Revendications**

1. Dispositif d'échantillonnage de signal haute fréquence (S) qui se propage dans une structure de propagation (L), le dispositif comprenant un premier étage (A1, I1, C1) et un deuxième étage (A2, I2, C2) en série avec le premier étage, l'entrée du premier étage étant reliée à la structure de propagation, chaque étage comprenant un interrupteur (I1, I2) et une capacité de sortie (C1, C2) en sortie de l'étage, le dispositif étant apte à prélever à un instant t1 un premier échantillon dans la capacité de sortie du premier étage et, à un instant t2 supérieur à t1, un deuxième échantillon dans la capacité de sortie du deuxième étage, la durée de vie du deuxième échantillon dans le deuxième étage étant supérieure à la durée de vie du premier échantillon dans le premier étage, **caractérisé en ce qu'**il comprend des moyens pour commander les interrupteurs des premier et deuxième étages de sorte que les premier et deuxième étage soient dans un état passant avant échantillonnage et, successivement, dans un état non passant lors des prélèvements des premier et deuxième échantillons et **en ce qu'**une charge de la capacité de sortie du premier étage est à chaque instant l'image d'un niveau de tension du signal haute fréquence sur la ligne de propagation quand l'interrupteur du premier étage est dans l'état passant.

2. Dispositif d'échantillonnage selon la revendication 1 dans lequel, aux instants supérieurs à t1 et inférieurs à t2 :

   - la capacité de sortie C1 du premier étage se décharge dans une résistance de fuite $r1_{off}$ qui est présente aux bornes de la capacité C1, et
   - la capacité de sortie C2 du deuxième étage se charge à travers une résistance $r2_{on}$ de l'interrupteur (I2) du deuxième étage à l'état passant, la condition suivante étant réalisée :

$$r1_{off} \times C1 = F \times r2_{on} \times C2,$$

   où
   F est un facteur multiplicatif très sensiblement supérieur à 1.

3. Dispositif selon la revendication 2, dans lequel, à l'instant t2, la tension aux bornes de la capacité C2 est sensiblement égale à la tension aux bornes de la capacité C1.

4. Dispositif d'échantillonnage selon l'une quelconque des revendications précédentes, dans lequel le premier étage comprend un premier amplificateur suiveur de tension (A1) qui est monté en série entre la structure de propagation et l'interrupteur du premier étage et le deuxième étage comprend un deuxième amplificateur suiveur de tension (A2) qui est monté en série entre la sortie du premier étage et l'interrupteur du deuxième étage.

5. Dispositif selon l'une quelconque des revendications précédentes dans lequel un amplificateur (Aa) monté en série avec un interrupteur (Ia) commandé par un signal de commande (Ka) est monté en série entre la ligne de propagation et le premier étage de façon à accroître l'isolation d'impédance entre la structure de propagation et les circuits situés en amont du premier étage.

6. Dispositif selon l'une quelconque des revendications précédentes, **caractérisé en ce qu'**il comprend un étage tampon de sortie (A3, R1) pour recopier l'état de tension aux bornes de la capacité de sortie du deuxième étage.

7. Dispositif selon la revendication 6, **caractérisé en ce qu'**il comprend un échantillonneur-bloqueur (C3, R2, A4, I3) pour échantillonner le signal prélevé en sortie de l'étage tampon de sortie (A3, R1).

8. Système d'échantillonnage de signal haute fréquence se propageant dans une structure de propagation, **caractérisé en ce qu'**il comprend au moins un dispositif d'échantillonnage selon l'une quelconque des revendications 1 à 7 pour prélever un échantillon de signal.

9. Système d'échantillonnage selon la revendication 8, **caractérisé en ce qu'**il comprend :

   - une succession d'amplificateurs (AR) placés en série dans la structure de propagation,
   - N dispositifs d'échantillonnage en parallèle qui prélèvent N échantillons de signal sur un tronçon de ligne compris entre deux amplificateurs successifs, et

- un ensemble de circuits de retard ($\Delta$), chaque circuit de retard ($\Delta$) permettant de retarder les premier et deuxième signaux de commande (K1, K2) d'une durée sensiblement égale à la durée que met le signal pour traverser un amplificateur (AR).

10. Système d'échantillonnage selon la revendication 9, **caractérisé en ce que** N=12.

11. Analyseur de transitoire, **caractérisé en ce qu'**il comprend au moins un dispositif d'échantillonnage selon l'une quelconque des revendications 1 à 7.

12. Procédé d'échantillonnage de signal haute fréquence qui se propage dans une structure de propagation (L), l'échantillonnage étant effectué par un dispositif d'échantillonnage qui comprend un premier étage et un second étage en série avec le premier étage, l'entrée du premier étage étant reliée à la structure de propagation, chaque étage comprenant un interrupteur et une capacité de sortie en sortie de l'étage, un premier échantillon étant prélevé à un instant t1 dans la capacité de sortie du premier étage et un deuxième échantillon étant prélevé, à un instant t2 supérieur à t1, dans la capacité de sortie du deuxième étage, la durée de vie du deuxième échantillon dans le deuxième étage étant supérieure à la durée de vie du premier échantillon dans le premier étage, **caractérisé en ce que :**

- les interrupteurs des premier et second étages sont commandés afin d'être passants avant échantillonnage, la charge de la capacité de sortie (C1) du premier étage étant à chaque instant l'image du niveau de tension du signal sur la ligne de propagation ;
- le prélèvement, à un instant t1, du premier échantillon dans la capacité de sortie du premier étage rend non-passant l'interrupteur du premier étage ; puis
- le prélèvement, à un instant t2 supérieur à t1, du deuxième échantillon dans la capacité de sortie du deuxième étage (C2) rend non-passant l'interrupteur du deuxième étage.

13. Procédé d'échantillonnage selon la revendication 12, dans lequel, aux instants t supérieur à t1 et inférieurs ou égal à t2 :

- la capacité de sortie C1 du premier étage se décharge dans une résistance de fuite $r1_{orr}$ qui est présente aux bornes de la capacité C1, et
- la capacité de sortie C2 du deuxième étage se charge à travers une résistance $r2_{on}$ de l'interrupteur (I2) du deuxième étage à l'état passant, la condition suivante étant réalisée :

$$r1_{off} \times C1 = F \times r2_{on} \times C2,$$

où
F est un facteur multiplicatif très sensiblement supérieur à 1.

14. Procédé selon la revendication 13, dans lequel, à l'instant t2, la tension aux bornes de la capacité C2 est sensiblement égale à la tension aux bornes de la capacité C1.

15. Procédé selon l'une quelconque des revendications 12 à 14, dans lequel un étage tampon de sortie recopie l'état de tension aux bornes de la capacité de sortie du deuxième étage.

16. Procédé selon la revendication 15, dans lequel un échantillonneur-bloqueur échantillonne le signal prélevé en sortie de l'étage tampon.

**Claims**

1. Sampling device for a high frequency signal (S) that propagates in a propagation structure (L), the device comprising a the first stage (A1, I1, C1) and a second stage (A2, I2, C2) in series with the first stage, the input of the first stage being connected to the propagation structure, each stage comprising a switch (I1, 12) and an output capacitor (C1, C2) at the output stage, the device being able to take at a time t1 a first signal sample in the ouput capacitor of the first stage and, at a time t2 greater than t1, a second signal sample in the output capacitor of the second stage, the life-time of the second sample in the second capacitor being longer than the life-time of the first sample in the first stage, **characterized in that** it comprises means for controlling the switches of the first and second stages so that the first and second stages are in an ON state before sampling and, successively, in an OFF state when are taken the first and second samples and **in that** a charge of the output capacitor of the first stage is at every moment the image of a voltage level of the high frequency signal in the propagation structure when the switch of the first stage is in the ON state.

2. Sampling device of claim 1 wherein, at times greater than t1 and smaller than t2:

   - the output capacitor C1 of the first stage discharges in a leakage resistor $r1_{off}$ which is at the capacitor C1 terminals, and
   - the output capacitor C2 of the second stage is charged through a resistor $r2_{on}$ of the switch (12) of the second stage in the ON state, the following condition being realised:

$$r1_{off} \times C1 = F \times r2_{on} \times C2,$$

   wherein F is a multiplicative factor greater than 1.

3. Sampling device according to claim 2 wherein, at the time t2, the voltage at the terminals of the capacitor C2 is approximately equal to the voltage at the terminals of the capacitor C1.

4. Sampling device according to any preceding claim wherein the first stage comprises a first voltage follower amplifier (A1) connected in series between the propagation structure (L) and the switch of the first stage and the second stage comprises a second voltage follower amplifier (A2) connected in series between the output of the first satege and the switch of the second stage.

5. Sampling device according to any preceding claim wherein an amplifier (Aa) connected in series with a switch (Ia) controlled by a control signal (Ka) is connected in series between the propagation structure and the first stage so that the impedance isolation between the propagation structure and the circuits which are located upstream from the first stage is increased.

6. Sampling device according to any preceding claim wherein an output buffer (A3, R1) copies the voltage state at the terminals of the output capacitor of the second stage.

7. Sampling device according to claim 6 wherein a sample and hold circuit (C3, R2, A4, 13) samples the signal taken at the output from the output buffer stage (A3, R1).

8. Sampling system for a high frequency signal propagating in a propagation structure, **characterized in that** it comprises at least one sampling device according to any one of claims 1 to 7 to take a signal sample.

9. Sampling system according to claim 8, **characterized in that** it comprises:

   - a sequence of amplifiers (AR) placed in series in the propagation structure,
   - N sampling devices in parallel that take N signal samples on a line segment between two successive amplifiers, and
   - a set of delay circuits ($\Delta$), each delay circuit ($\Delta$) delaying the first and second control signals (K1, K2) by a duration approximately equal to the duration taken by a signal to pass through an amplifier (AR).

10. Sampling system according to claim 9, **characterized in that** N = 12.

11. Transient analyzer, **characterized in that** it comprises at least one sampling device according to any one of claims 1 to 7.

12. Method for sampling a high frequency signal that propagates in a propagation structure (L), the sampling being implemented by a sampling device that comprises a the first stage and a second stage in series with the first stage, the input of the first stage being connected to the propagation structure, each stage comprising a switch and an output capacitor at the output stage, a first sample being at a time t1 in the ouput capacitor of the first stage and a second sample being taken, at a time t2 greater than t1, in the output capacitor of the second stage, the life-time of the second sample in the second capacitor being longer than the life-time of the first sample in the first stage, **characterized in that:**

- the switches of the first and second stages are controlled to be in an ON state before sampling, the charge of the output capacitor (C1) of the first stage being at every moment the image of a voltage level of the signal in the propagation structure;
- the sampling, at a time t1, of the first sample in the output capacitor of the first stage puts the switch of the first stage in an OFF stage; then
- the sampling, at time t2 greater than t1, of the second sample in the output capacitor of the second stage (C2) puts the switch of the second stage in an OFF stage.

**13.** Method according to claim 12, wherein, at times t greater than t1 and smaller than or equal to t2:

- the output capacitor C1 of the first stage discharges in a leakage resistor $r1_{off}$ which is at the capacitor C1 terminals, and
- the output capacitor C2 of the second stage is charged through a resistor $r2_{on}$ of the switch (12) of the second stage in the ON state, the following condition being realised:

$$r1_{off} \; x \; C1 = F \; x \; r2_{on} \; x \; C2,$$

wherein F is a multiplicative factor greater than 1.

**14.** Method according to claim 13 wherein the voltage at the terminals of the capacitor C2 is approximately equal to the voltage at the terminals of the capacitor C1.

**15.** Method according to any claim 12 to 14 wherein an output buffer copies the voltage state at the terminals of the output capacitor of the second stage.

**16.** Method according to claim 15 wherein a sample and hold circuit samples the signal taken at the output from the output buffer stage.

**Patentansprüche**

**1.** Vorrichtung zur Abtastung eines elektrischen Hochfrequenzsignals (S), das sich in einer Ausbreitungsstruktur (L) ausbreitet, wobei die Vorrichtung eine erste Stufe (A1, I1, C1) und zweite Stufe (A2, I2, C2), in Serie mit der ersten Stufe, umfasst und der Eingang der ersten Stufe mit der Ausbreitungsstruktur verbunden ist, jede Stufe einen Schalter (I1, 12) und eine Ausgangskapazität (C1, C2) am Ausgang der Stufe umfasst, und die Vorrichtung dabei fähig ist, zu einem Zeitpunkt t1 an der Ausgangskapazität der ersten Stufe einen ersten Abtastwert abzugreifen, und zu einem Zeitpunkt t2, höher als t1, an der Ausgangskapazität der zweiten Stufe einen zweiten Abtastwert abzugreifen, wobei die Lebensdauer des zweiten Abtastwerts in der zweiten Stufe größer ist als die Lebensdauer des ersten Abtastwerts in der ersten Stufe, **dadurch gekenntzeichnet, dass** sie Einrichtungen zum Steuern der Schalter der ersten und der zweiten Ausgangsstufe umfasst, so dass sich die erste und die zweite Ausgangsstufe vor der Abtastung in einem Durchlasszustand befinden und sukzessive, während der Abtastungen des ersten und zweiten Abtastwerts, in einem Nichtdurchlasszustand, und **dadurch**, dass eine Ladung der Ausgangskapazität der ersten Stufe zu jedem Zeitpunkt die Abbildung eines Spannungspegels des Hochfrequenzsignals in der Ausbreitungsleitung ist, wenn sich der Schalter der ersten Stufe im Durchlasszustand befindet.

**2.** Abtastvorrichtung nach Anspruch 1, bei der zu Zeitpunkten höher als t1 und niedriger als t2:

- die Ausgangskapazität C1 der ersten Stufe sich in einen Ableitvidersiand $r1_{off}$ entlädt, vorgesehen an den Anschlüssen der Kapazität C1, und
- die Ausgangskapazität C2 der zweiten Stufe sich durch einen Widerstand $r2_{on}$ des Schalters (I2) der zweiten Stufe im Durchlasszustand auflädt, wobei die folgende Bedingung realisiert wird:

$$r1_{off} \times C1 = F \times r2_{on} \times C2$$

wobei F ist ein Multiplikationsfaktor, sehr viel größer als 1, ist.

3. Vorrichtung nach Anspruch 2, bei der zum Zeitpunkt t2 die Spannung an den Anschlüssen der Kapazität C2 im Wesentlichen gleich der Spannung an den Anschlüssen der Kapazität C1 ist.

4. Abtastvorrichtung nach einem der vorangehenden Ansprüche, bei dem die erste Stufe einen ersten Spannungsfolgerverstärker (A1) umfasst, in Serie geschaltet zwischen der Ausbreitungsstruktur und dem Schalter der ersten Stufe, und die zweite Stufe einen zweiten Spannungsfolgerverstärker (A2) umfasst, in Serie geschaltet zwischen dem Ausgang der ersten Stufe und dem Schalter der zweiten Stufe.

5. Vorrichtung nach einem der vorhergehenden Ansprüche, bei dem ein Verstärker (Aa), in Serie geschaltet mit einem durch ein Steuersignal (Ka) gesteuerten Schalter (Ia), in Serie geschaltet ist zwischen der Ausbreitungsleitung und der ersten Stufe, um die Impedanzisolation zwischen der Ausbreitungsstruktur und den vor der ersten Stufe befindlichen Schaltungen zu erhöhen.

6. Vorrichtung nach einem der vorhergehenden Ansprüche, **dadurch gekennzeichnet, dass** sie eine Ausgangspufferstufe (A3, R1) umfasst, um den Spannungszustand an den Anschlüssen der Ausgangskapazität der zweiten Stufe abzukopieren.

7. Vorrichtung nach Anschluss 6, **dadurch gekennzeichnet, dass** sie eine Abtast- und Halteschaltung (C3, R2, A4, 13) umfasst, um das am Ausgang der Ausgangspufferstufe (A3, R1) abgegriffene Signal abzutasten.

8. System zur Abtastung eines sich in einer Ausbreitungsstruktur ausbreitenden Hochfrequenzsignals, **dadurch gekennzeichnet, dass** es wenigstens eine Abtastvorrichtung nach einem der Ansprüche 1 bis 7 umfasst, um einen Signalabtastwert zu entnehmen.

9. Abtastsystem nach Anspruch 8, **dadurch gekennzeichnet, dass** es umfasst:

- eine Folge von in Serie geschalteten Verstärkern (AR) in der Ausbreitungsstruktur,
- N parallelgeschaltete Abtastvorrichtungen zur Entnahme von N Signalabtastwerten in einem zwischen zwei aufeinanderfolgenden Verstärkern enthaltenen Leitungsabschnitt, und
- eine Menge bzw. Anzahl von Verzögerungsschaltungen ($\Delta$), wobei jede Verzögerungsschaltung ($\Delta$) ermöglicht, das erste und zweite Steuersignal (K1 K2) um eine Dauer zu verzögern, die im Wesentliche gleich der Dauer ist, die das Signal benötigt, um einen Verstärker (AR) zu durchqueren.

10. Abtastsystem nach Anspruch 9, **dadurch gekennzeichnet, dass** N=12 ist.

11. Transientenanalysator, **dadurch gekennzeichnet, dass** er wenigstens eine Abtastvorrichtung nach einem der Ansprüche 1 bis 7 umfasst.

12. Verfahren zur Abtastung eines Hochfrequenzsignals, das sich in einer Ausbreitungsstruktur (L) ausbreitet, wobei die Abtastung durch eine Abtastvorrichtung erfolgt, die eine erste Stufe und zweite Stufe, in Serie mit der ersten Stufe, umfasst, der Eingang der ersten Stufe mit der Ausbreitungsstruktur verbunden ist, jede Stufe einen Schalter und eine Ausgangskapazität am Ausgang der Stufe umfasst, an der Ausgangskapazität der ersten Stufe zu einem Zeitpunkt t1 ein erster Abtastwert abgegriffen wird und zu einem Zeitpunkt t2, höher als t1, an der Ausgangskapazität der zweiten Stufe ein zweiter Abtastwert abgegriffen wird, wobei die Lebensdauer des zweiten Abtastwerts in der zweiten Stufe größer ist als die Lebensdauer des ersten Abtastwerts in der ersten Stufe, **dadurch gekennzeichnet, dass:**

- die Schalter der ersten und zweiten Stufe so gesteuert werden, dass sie sich vor der Abtastung im Durchlasszustand befinden, wobei die Ladung der Ausgangskapazität (C1) der ersten Stufe zu jedem Zeitpunkt die Abbildung des Spannungspegels des Hochfrequenzsignals in der Ausbreitungsleitung ist;
- das Abgreifen des ersten Abtastwerts zu einem Zeitpunkt t1 an der Ausgangskapazität der ersten Stufe den Schalter der ersten Stufe undurchlässig macht; dann
- das Abgreifen des zweiten Abtastwerts zu einem Zeitpunkt t2 an der Ausgangskapazität der zweiten Stufe (C2) den Schalter der zweiten Stufe undurchlässig macht.

13. Abtastverfahren nach Anspruch 12, bei dem zu Zeitpunkten t höher als t1 und niedriger oder gleich t2:

- die Ausgangskapazität C1 der ersten Stufe sich in einen Ableitwiderstand $r1_{off}$ entlädt, vorgesehen an den Anschlüssen der Kapazität C1, und
- die Ausgangskapazität C2 der zweiten Stufe sich durch einen Widerstand $r2_{on}$ des Schalters (12) der zweiten Stufe im Durchlasszustand auflädt, wobei die folgende Bedingung realisiert wird:

$$r1_{off} \times C1 = F \times r2_{on} \times C2,$$

wobei F ist ein Multiplikationsfaktor, sehr viel größer als 1, ist.

14. Verfahren nach Anspruch 13, bei dem zum Zeitpunkt t2 die Spannung an den Anschlüssen der Kapazität C2 im Wesentlichen gleich der Spannung an den Anschlüssen der Kapazität C1 ist.

15. Verfahren nach einem der Ansprüche 12 bis 14, bei dem eine Ausgangspufferstufe den Spannungszustand an den Anschlüssen der Ausgangskapazität der zweiten Stufe abkopiert.

16. Verfahren nach Anschluss 15, bei dem eine Abtast- und Halteschaltung das am Ausgang der Ausgangspufferstufe abgegriffene Signal abtastet.

7

2

1

3

4

5

6

# FIG. 1

8

8A    8B    8C

9    10

11

# FIG. 2

FIG. 3

EP 1 390 769 B1

FIG. 4

FIG. 5

FIG. 6

EP 1 390 769 B1

FIG. 7

EP 1 390 769 B1

FIG. 8

ARM

TRIGEXT

TRIGASGA

TRIGHF

TRIGBF

FINECH

SH

LECTURE

ACQUISITION
250 ns

DIGITALISATION

EP 1 390 769 B1

19

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- GB 2157519 A
- US 5471162 A
- FR 9706534